# FASCICULE DE BREVET EUROPEEN

(11) **EP 3 182 281 B1**
(45) Date de publication et mention de la délivrance du brevet: **30.03.2022**
(21) Numéro de dépôt: 16203072.0
(22) Date de dépôt: 09.12.2016
(51) Int. Cl.: G06F 8/65, G06F 8/656, H04B 3/54, G06F 11/14, G06F 9/445

(54) **PROCEDE DE TRANSFERT D'UNE NOUVELLE VERSION D'UN LOGICIEL A AU MOINS UN COMPTEUR ELECTRIQUE VIA UN RESEAU DE COMMUNICATION**
ÜBERTRAGUNGSVERFAHREN EINER NEUEN SOFTWARE-VERSION AN MINDESTENS EINEN STROMZÄHLER ÜBER EIN KOMMUNIKATIONSNETZ
METHOD FOR TRANSFERRING A NEW VERSION OF A SOFTWARE PROGRAM TO AT LEAST ONE ELECTRIC METER VIA A COMMUNICATION NETWORK

(30) Priorité: 11.12.2015 FR 1562197
(43) Date de publication de la demande: 21.06.2017
(73) Titulaire: SAGEMCOM ENERGY & TELECOM SAS, 92500 Rueil-Malmaison (FR)
(72) Inventeur: ROTER, Ziv, 92500 RUEIL MALMAISON (FR); SERGI, Jérémie, 92500 RUEIL MALMAISON (FR)
(74) Mandataire: Cabinet Le Guen Maillet

(56) Documents cités:
- US-B2- 9 024 780
- Kema Consulting: "P3 Companion Standard - Dutch Smart Meter Requirements", , 18 avril 2008 (2008-04-18), pages 1-73, XP055304605, Extrait de l'Internet: URL:http://zooi.widodh.nl/got/Dutch_Smart_ Meter_Requirements_v2.2_final_P3.pdf [extrait le 2016-09-21]
- GORDAN STRUKLEC ET AL: "Implementing DLMS/COSEM in smart meters", ENERGY MARKET (EEM), 2011 8TH INTERNATIONAL CONFERENCE ON THE EUROPEAN, IEEE, 25 mai 2011 (2011-05-25), pages 747-752, XP031902013, DOI: 10.1109/EEM.2011.5953109 ISBN: 978-1-61284-285-1
- KHEAKSONG ADISORN ET AL: "Packet transfer of DLMS/COSEM standards for smart grid", THE 20TH ASIA-PACIFIC CONFERENCE ON COMMUNICATION (APCC2014), IEEE, 1 octobre 2014 (2014-10-01), pages 391-396, XP032765655, DOI: 10.1109/APCC.2014.7092843

## Description

La présente invention concerne le transfert d'une nouvelle version d'un logiciel depuis un dispositif concentrateur vers au moins un compteur électrique dans un sous-réseau de communication par courants porteurs en ligne.

Dans le cadre de réseaux d'alimentation électrique de type AMM (« Automated Meter Management » en anglais), des communications sont établies entre des compteurs électriques, dits intelligents (« smart meters » en anglais), et un dispositif concentrateur de données (« data concentrator » en anglais), parfois appelé *nœud de base* (« base node » en anglais) ou *coordinateur* (« coordinator » en anglais). C'est le cas par exemple dans les spécifications PRIME (« PoweRline Intelligent Metering Evolution » en anglais) ou G3-PLC. Les échanges entre les compteurs électriques et le dispositif concentrateur de données s'appuient sur des communications par courants porteurs en ligne (« PowerLine Communications » en anglais). Le dispositif concentrateur est alors la racine du réseau de communication, qui a une topologie logique sous forme d'arbre pour permettre d'étendre la portée des communications. Des dispositifs nœuds servent alors de relais pour le compte d'autres dispositifs nœuds du réseau de communication lorsque ces derniers n'arrivent pas à recevoir directement des informations du dispositif nœud racine.

La 12e édition du « Bluebook : COSEM Interface Classes and OBIS Object Identification System » édité par le DLMS User Association décrit une méthode en deux phases pour déployer une nouvelle version de logiciel, décomposée en blocs, auprès des compteurs électriques à partir du dispositif concentrateur : une première phase pendant laquelle le transfert est effectué sans retransmission, c'est-à-dire sans se préoccuper de savoir si un bloc est correctement reçu avant de passer au transfert du bloc suivant, et une seconde phase ultérieure à la première phase pendant laquelle le transfert de chaque bloc n'ayant pas été correctement reçu pendant la première phase est effectué. Lorsque le transfert est interrompu pour au moins un compteur électrique, par exemple par déconnexion dudit ou desdits compteurs électriques, le transfert reprend ultérieurement par remise en œuvre de la première phase. Cette approche manque toutefois d'efficacité.

Il est connu le document de brevet US 9,024,780 B2 qui divulgue la possibilité d'une phase de téléchargement de mise à jour logicielle, sous forme de communication point-multipoint (*multicast*), dans laquelle le téléchargement s'effectue par blocs (paquets).

Il est connu le document « P3 Companion Standard - Dutch Smart Meter Requirements », 2008, Kema Consulting, qui divulgue un transfert en voie descendante (*downlink*) par blocs pour effectuer une mise à jour logicielle en deux phases.

Il est connu le document « Implementing DLMS/COSEM in smart meters », 2011, GORDAN STRUKLEC et al, qui évoque les difficultés d'implémentation du protocole DLMS/COSEM dans les compteurs électriques, notamment en termes de gestion de ressources.

Il est connu le document « Packet Transfer of DLMS/COSEM standards for smart grid », 2014, KHEAKSONG ADISORN et al, qui étudie des questions de transfert de paquets dans le cadre du protocole DLMS/COSEM.

Il est alors souhaitable de pallier ces inconvénients de l'état de la technique, et notamment de permettre d'augmenter l'efficacité du transfert d'une nouvelle version d'un logiciel destinée à des compteurs électriques dans un contexte de réseaux d'alimentation électrique de type AMM dans lequel des déconnexions desdits compteurs électriques peuvent survenir.

L'invention concerne un procédé de transfert d'une nouvelle version d'un logiciel tel que défini dans la revendication 1

Ainsi, en reprenant le transfert selon la seconde phase lorsqu'une déconnexion-reconnexion de compteur électrique survient, l'efficacité du transfert de la nouvelle version du logiciel est améliorée, puisque, grâce au contexte sauvegardé par chaque compteur électrique, seuls les blocs qui n'ont pas été préalablement correctement reçus sont alors transférés. Chaque compteur électrique sauvegardant son propre contexte, la gestion de l'éventuelle péremption de chaque contexte est facilitée lors d'une éventuelle déconnexion dudit compteur électrique (puisque le réseau de communication ne sait a priori pas si le compteur électrique va être effectivement reconnecté).

Selon un mode de réalisation particulier, le transfert vers au moins un compteur électrique est interrompu par déconnexion dudit ou desdits compteurs électriques, et le transfert de la nouvelle version du logiciel vers ledit ou lesdits compteurs électriques reprend selon la seconde phase lorsque ledit ou lesdits compteurs électriques se reconnectent, quel que soit le sous-réseau de communication auquel ledit ou lesdits compteurs électriques se reconnectent. Ainsi, chaque compteur électrique sauvegardant son propre contexte, la gestion de l'accès au contexte est facilitée dans le cas où ledit compteur électrique est déconnecté d'un sous-réseau de communication pour être reconnecté à un autre réseau de communication.

Selon un mode de réalisation particulier, au démarrage du transfert, un drapeau au sein du contexte indique, associé à chaque bloc identifié par son numéro de séquence, que ledit bloc est considéré comme non correctement reçu, et chaque compteur recevant correctement un bloc l'indique par modification du drapeau associé audit bloc.

Selon un mode de réalisation particulier, à chaque bloc correctement reçu par un compteur électrique, ledit compteur électrique modifie son contexte pour indiquer que ledit bloc a été correctement reçu, et, lors de ladite première phase, le transfert de la nouvelle version du logiciel à chaque compteur électrique concerné est à l'initiative du dispositif concentrateur auquel ledit compteur électrique est rattaché. De plus, lors de la seconde phase, chaque dispositif concentrateur requiert auprès de chaque compteur électrique concerné dans le sous-réseau de communication auquel ledit dispositif concentrateur appartient de lui fournir le contexte dudit compteur électrique, et transmet à son initiative à chaque compteur électrique concerné chaque bloc qui n'a pas été correctement reçu d'après le contexte dudit compteur électrique, et ce de manière répétée jusqu'à ce que l'une des conditions suivantes soit remplie : tous les blocs sont correctement reçus par ledit compteur électrique ; et ledit compteur électrique est déconnecté.

L'invention concerne également un réseau de communication défini tel que dans la revendication 5.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la Fig. 1 illustre schématiquement un réseau de communication dont la topologie logique est sous forme d'arbre, déployé sur un réseau d'alimentation électrique et dans lequel l'invention peut être implémentée ;
- la Fig. 2 illustre schématiquement un exemple d'architecture matérielle d'un dispositif de communication du réseau de communication de la Fig. 1 ; et

- la Fig. 3 illustre schématiquement un algorithme de mise à jour logicielle au sein du réseau de communication de la Fig. 1.

L'invention concerne le transfert d'une nouvelle version de logiciel bloc par bloc en deux phases : une première phase pendant laquelle le transfert est effectué sans retransmission, c'est-à-dire sans se préoccuper de savoir si un bloc est correctement reçu avant de passer au transfert du bloc suivant, et une seconde phase ultérieure à la première phase pendant laquelle le transfert de chaque bloc n'ayant pas été correctement reçu pendant la première phase est effectué. Lorsque le transfert de la nouvelle version du logiciel vers au moins un compteur électrique est interrompu, la reprise ultérieure du transfert de la nouvelle version du logiciel vers ledit ou lesdits compteurs électriques s'effectue selon la seconde phase, c'est-à-dire sans tenir compte du fait que l'interruption ait eu lieu en cours de première phase, en cours de seconde phase, ou entre la première phase et la seconde phase. Le transfert reprend ainsi par le transfert des blocs qui n'ont pas été correctement reçus (un bloc non reçu étant un bloc non correctement reçu). Comme détaillé ci-après, l'invention s'inscrit plus particulièrement dans un cadre de mise à jour, via un sous-réseau de communication par courants porteurs en ligne, d'un logiciel destiné à être exécuté par des compteurs électriques, dits intelligents (« smart meters » en anglais).

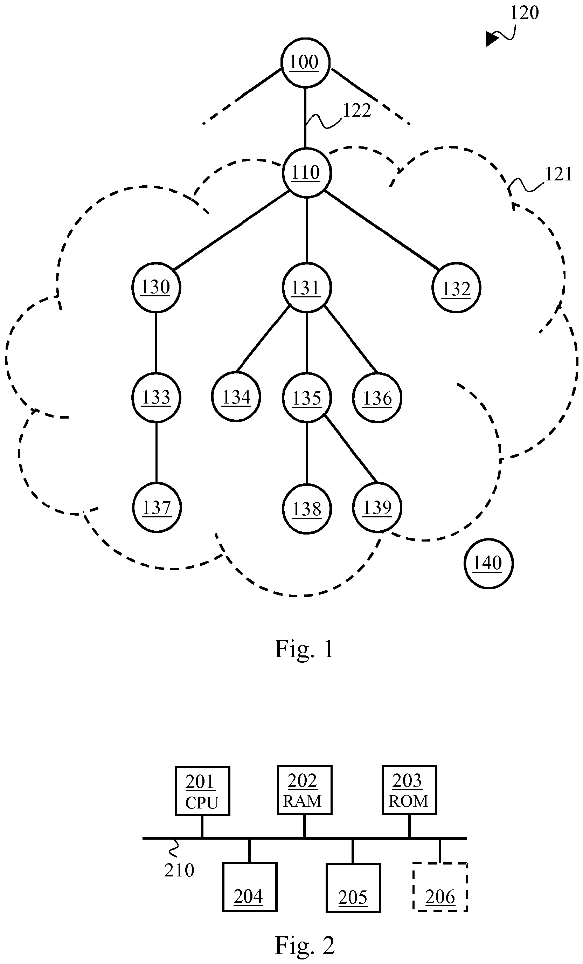

La Fig. 1 illustre schématiquement un réseau de communication 120 comportant au moins un sous-réseau de communication 121 ayant une topologie logique sous forme d'arbre déployé sur un réseau d'alimentation électrique et dans lequel l'invention peut être implémentée.

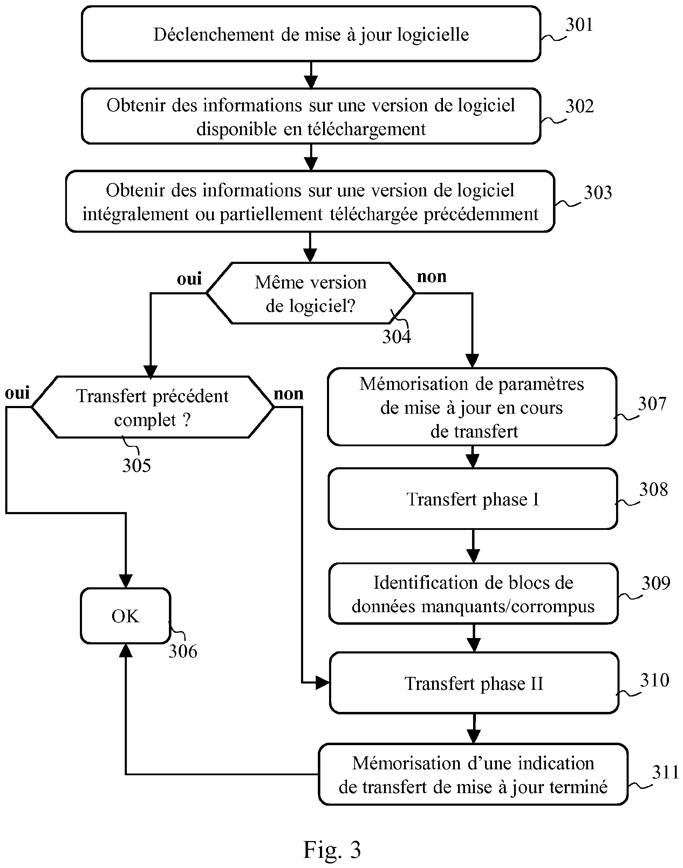

Le sous-réseau de communication 121 est en forme d'arbre dont un dispositif nœud particulier 110, appelé *dispositif concentrateur* ou *nœud de base* ou *coordinateur,* est la racine. Le sous-réseau de communication 121 est destiné à permettre de connecter une pluralité de dispositifs nœuds au dispositif concentrateur 110. Dans le cadre de la Fig. 1, les dispositifs nœuds que le sous-réseau de communication 121 vise à connecter sont des compteurs électriques, dits intelligents (« smart meters » en anglais). Le sous-réseau de communication 121 permet ainsi d'établir des communications par courants porteurs en ligne (« powerline communications » en anglais), afin que le dispositif concentrateur 110 puisse notamment procéder automatiquement à des opérations de collecte de relevés de comptage de consommation électrique, ledit comptage étant effectué par les compteurs électriques vis-à-vis d'installations électriques que lesdits compteurs électriques sont respectivement en charge de superviser, et afin que le dispositif concentrateur 110 puisse procéder à des opérations de mise à jour logicielle auprès des compteurs électriques du sous-réseau de communication 121, tel que décrit ci-après en relation avec la Fig. 3.

Le sous-réseau de communication 121 est préférentiellement de type PRIME ou G3-PLC.

Le réseau de communication 120 comporte en outre un serveur 100 auquel le dispositif concentrateur 110 est connecté via un lien de communication 122. Le lien de communication 122 est par exemple de type GPRS (« General Packet Radio Service » en anglais), UMTS (« Universal Mobile Télécommunication System » en anglais), LTE (« Long-Term Evolution » en anglais), ou l'Internet. Le dispositif concentrateur 110 effectue, au sein du sous-réseau de communication 121, lesdites opérations de collecte de relevés de comptage et de mise à jour logicielle pour le compte du serveur 100. En d'autres termes, le dispositif concentrateur 110 collecte les relevés de comptage auprès des compteurs électriques qui lui sont rattachés (*i.e.* les compteurs électriques du sous-réseau de communication 121) et gère les éventuels besoins de retransmission au sein du sous-réseau de communication 121, puis fournit lesdits relevés au serveur 100 pour traitement ; de plus, le dispositif concentrateur 110 assure la mise à jour logicielle des compteurs électriques qui lui sont rattachés, bloc par bloc, tel que décrit ci-après en relation avec la Fig. 3.

Lorsque le réseau de communication 120 comporte une pluralité de sous-réseaux de communication ayant des topologies logiques respectives sous forme d'arbre déployé sur un réseau d'alimentation électrique (comme le sous-réseau de communication 121), le dispositif concentrateur de chaque sous-réseau de communication est ainsi connecté au serveur 100 via un tel lien de communication 122. Les opérations de collecte de relevés de comptage et de mise à jour logicielle sont alors effectuées par chaque dispositif concentrateur, au sein de leur sous-réseau de communication respectifs, pour le compte du serveur 100.

Des échanges au format DLMS/COSEM (« Device Language Message Specification / Companion Specificartion for Energy Metering » en anglais), tels que décrits dans le document normatif IEC 62056-5-3 et dans la 12e édition du « Bluebook : COSEM Interface Classes and OBIS Object Identification System » édité par le DLMS User Association, sont ainsi préférentiellement utilisés pour effectuer les opérations de relevé de comptage et de mise à jour logicielle, les opérations de mise à jour logicielle étant toutefois conformes au comportement décrit ci-après en relation avec la Fig. 3.

Il est nécessaire de comprendre que, dans le sous-réseau de communication 121, un signal émis par un dispositif nœud n'est en général pas visible en tout point dudit sous-réseau de communication. Chaque dispositif nœud émetteur de signaux dispose alors d'un « domaine de voisinage », c'est-à-dire d'un sous-ensemble dudit sous-réseau de communication 121 dans lequel tout dispositif nœud connecté peut recevoir de manière intelligible lesdits signaux. Le domaine de voisinage correspond à la portée des signaux émis, en fonction de paramètres prédéterminés de transmission (e.g. puissance, schéma de modulation et de codage...) du dispositif nœud émetteur du signal et également en fonction de caractéristiques du canal de communication (atténuation, bruit, impédance...). Chaque dispositif nœud dudit sous-réseau de communication dispose ainsi de son propre domaine de voisinage. Pour permettre d'étendre la portée des communications à courants porteurs en ligne, des dispositifs nœuds jouent le rôle de relais de données entre d'autres dispositifs nœuds et le dispositif concentrateur 110. Un tel dispositif relais est appelé *commutateur* (« switch » en anglais) dans les spécifications PRIME, où *routeur* dans les spécifications G3-PLC. Certaines communications entre des dispositifs nœuds et le dispositif concentrateur 110 peuvent nécessiter plusieurs relais de données successifs. Un dispositif nœud ne jouant pas le rôle de relais est appelé *dispositif terminal.* Une telle structure définit donc des rattachements de dispositifs nœuds les uns aux autres pour former la topologie logique en forme d'arbre, c'est-à-dire la hiérarchie constituant le sous-réseau de communication 121. Chaque dispositif nœud du sous-réseau de communication 121 est ainsi associé à un niveau hiérarchique, correspondant typiquement à la quantité de dispositifs relais via lesquels ledit dispositif nœud doit passer pour atteindre la racine du sous-réseau de communication 121, c'est-à-dire le dispositif concentrateur 110. Outre le relais de données, les dispositifs relais émettent des balises, qui permettent aux dispositifs nœuds qui leur sont rattachés de se synchroniser avec le sous-réseau de communication 121.

Un tel sous-réseau de communication sous forme d'arbre est représenté sur la Fig. 1. Un dispositif nœud terminal 132 est directement rattaché au dispositif concentrateur 110. Deux autres dispositifs nœuds 130 et 131 sont aussi directement rattachés au dispositif concentrateur 110. Ces deux dispositifs nœuds 130 et 131 jouent le rôle de dispositifs relais entre le dispositif concentrateur 110 et d'autres dispositifs nœuds. Le dispositif nœud 130 joue le rôle de dispositif relais entre le dispositif concentrateur 110 et un dispositif nœud 133 qui, lui-même, joue le rôle de dispositif relais entre le dispositif nœud 130 et un dispositif terminal 137. Les communications entre le dispositif concentrateur 110 et le dispositif terminal 137 passent donc par deux dispositifs relais successifs, à savoir les dispositifs relais 130 et 133. Le dispositif nœud 131 joue le rôle de dispositif relais entre le dispositif concentrateur 110 et trois autres dispositifs nœuds 134, 135 et 136. Les dispositifs nœuds 134 et 136 sont des dispositifs terminaux, et le dispositif nœud 135 joue le rôle de dispositif relais entre le dispositif nœud 131 et deux dispositifs terminaux 138 et 139. Ainsi, les dispositifs nœuds 130, 131 et 132 sont associés à un niveau hiérarchique de valeur « 0 », les dispositifs nœuds 133, 134, 135, 136 sont associés à un niveau hiérarchique de valeur « 1 », et ainsi de suite.

Un dispositif nœud qui n'est pas rattaché au réseau de communication 121 est un dispositif *déconnecté* (« disconnected » en anglais), tel que le dispositif nœud 140 sur la Fig. 1.

Il faut comprendre que la topologie logique du sous-réseau de communication 121 n'est pas figée. La Fig. 1 représente la topologie logique du sous-réseau de communication 121 à un instant donné. A cause notamment des phénomènes d'interférences (tels que bruit, atténuation, variation d'impédance, diaphonie, collision de signaux...), des dispositifs nœuds peuvent se trouver déconnectés du sous-réseau de communication 121 et cherchent alors à se réenregistrer au sein du réseau de communication 120. La topologie logique du sous-réseau de communication 121 à ce moment-là est alors probablement différente de la topologie logique du sous-réseau de communication 121 avant déconnexion desdits dispositifs nœuds, des dispositifs nœuds ayant alors été potentiellement déchus de leur rôle de relais et d'autres ayant alors été potentiellement promus pour jouer le rôle de relais. Lors de leur réenregistrement au sein du réseau de communication 120, les nœuds de communication ayant été déconnectés du sous-réseau de communication 121 vont chercher à se reconnecter au sous-réseau de communication 121 ou à un autre sous-réseau de communication du réseau de communication 120.

La Fig. 2 illustre schématiquement un exemple d'architecture matérielle d'un dispositif de communication du réseau de communication 120, que ce soit le serveur 100 ou, au sein du sous-réseau de communication 121, le dispositif concentrateur 110, un dispositif relais ou un dispositif terminal.

Considérons que la Fig. 2 représente schématiquement l'architecture d'un compteur électrique du sous-réseau de communication 121. Le compteur électrique comprend alors, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203 ; une unité de stockage ou un lecteur de support de stockage, tel qu'un lecteur de cartes SD (« Secure Digital » en anglais) 204 ou un disque dur HDD (« Hard Disk Drive » en anglais) ; et, au moins une interface de communication 205.

Lorsque l'architecture de la Fig. 2 représente un compteur électrique, ledit compteur électrique comporte une interface de communication 205 permettant au compteur électrique d'effectuer des communications par courants porteurs en ligne. Lorsque l'architecture de la Fig. 2 représente le serveur 100, ledit serveur 100 comporte une interface de communication 205 permettant au serveur 100 d'effectuer des communications via le lien de communication (comme le lien de communication 122) avec chaque dispositif concentrateur (tel que le dispositif concentrateur 110) du réseau de communication 120. Lorsque l'architecture de la Fig. 2 représente un dispositif concentrateur (tel que le dispositif concentrateur 110), ledit dispositif concentrateur comporte deux interfaces de communication 205, l'une permettant audit dispositif concentrateur d'effectuer des communications via le lien de communication (comme le lien de communication 122) qui connecte ledit dispositif concentrateur au serveur 100, et l'autre permettant audit dispositif concentrateur d'effectuer des communications par courants porteurs en ligne avec un ou plusieurs compteurs électriques.

Lorsque l'architecture de la Fig. 2 représente un compteur électrique, ledit compteur électrique comporte en outre une mémoire non volatile 206 dans laquelle ledit compteur électrique stocke un contexte, tel que décrit ci-après en relation avec la Fig. 3.

Le processeur 201 est capable d'exécuter des instructions chargées dans la RAM 202 à partir de la ROM 203, d'une mémoire externe (non représentée), d'un support de stockage (tel qu'une carte SD), ou d'un autre réseau de communication. Lorsque le compteur électrique est mis sous tension, le processeur 201 est capable de lire de la RAM 202 des instructions et de les exécuter. Le même principe s'applique lorsque l'architecture de la Fig. 2 représente le serveur 100 ou un dispositif concentrateur (tel que le dispositif concentrateur 110). Ces instructions forment un programme d'ordinateur causant la mise en œuvre, par le processeur 201, de tout ou partie du comportement décrit ci-après en relation avec la Fig. 3.

Tout ou partie du comportement décrit ci-après en relation avec la Fig. 3 peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

La Fig. 3 illustre schématiquement un algorithme de mise à jour logicielle au sein du réseau de communication 120. Un ou plusieurs compteurs électriques y sont considérés.

Dans une étape 301, une vérification de besoin de mise à jour logicielle est déclenchée pour au moins un compteur électrique du réseau de communication 120. Cette vérification peut être déclenchée par le serveur 100 lorsque le compteur électrique considéré s'enregistre auprès du réseau de communication 120, par exemple suite à une déconnexion du sous-réseau de communication 121. Une telle déconnexion peut être logique (perte du chemin de communication avec le dispositif concentrateur auquel ledit compteur électrique était rattaché) ou physique (arrêt effectif dudit compteur électrique). Cette vérification peut être déclenchée par le dispositif concentrateur 110 lorsque le compteur électrique considéré rejoint le sous-réseau de communication 121, par exemple suite à une déconnexion du réseau de communication 120. Cette vérification peut être déclenchée par le serveur 100 lorsqu'une nouvelle version logicielle est disponible pour un déploiement sur au moins une partie des compteurs électriques du réseau de communication 120. Cette vérification peut être déclenchée par le dispositif concentrateur 110 lorsqu'une nouvelle version logicielle est disponible pour un déploiement sur au moins une partie des compteurs électriques du sous-réseau de communication 121. Dans une autre variante de réalisation, la vérification de besoin de mise à jour logicielle est déclenchée par le compteur électrique considéré, par exemple de manière régulière et/ou lorsque le compteur électrique considéré s'enregistre auprès du réseau de communication 120.

Dans un mode de réalisation particulier, le dispositif concentrateur 110 peut volontairement interrompre le transfert de la nouvelle version logicielle, par exemple pour effectuer ou faire effectuer des tâches de plus haute importance dans le sous-réseau de communication 121. La vérification de besoin de mise à jour logicielle peut alors être déclenchée par le dispositif concentrateur 110 lorsque lesdites tâches sont achevées. Dans une variante de réalisation, la vérification de besoin de mise à jour logicielle peut alors être déclenchée par le compteur électrique considéré lorsque ledit compteur électrique a achevé la tâche qui lui a été confiée par le dispositif concentrateur 110.

Dans une étape 302 suivante, des informations sur une version du logiciel qui est disponible en téléchargement sont obtenues. Ces informations sont au moins un identifiant de version et une taille de logiciel. Dans la section 4.4.6.4 de la 12e édition du « Bluebook : COSEM Interface Classes and OBIS Object Identification System » édité par le DLMS User Association, ces informations sont désignées par la structure *image_to_activate_info,* dont les champs *image _to_activate_identification* et *image_to_activate_size* sont des paramètres correspondant respectivement à l'identifiant de la version du logiciel qui est disponible en téléchargement et la taille de la version du logiciel qui est disponible en téléchargement. Chaque nouvelle version du logiciel est fournie par le serveur 100 à chaque dispositif concentrateur du réseau de communication 120, avec éventuellement une indication de quels compteurs électriques du sous-réseau de communication par courants porteurs en ligne auquel appartient ledit dispositif concentrateur sont concernés par la mise à jour logicielle. L'étape 302 est préférentiellement effectuée par le dispositif concentrateur 110 en consultant en interne quelle version de logiciel (identifiant et taille) est stockée en mémoire dudit dispositif concentrateur 110 et mise à disposition des compteurs électriques du sous-réseau de communication 121. Dans une variante de réalisation, l'étape 302 est effectuée par le dispositif concentrateur 110 en consultant en interne quelle version de logiciel (identifiant et taille) est stockée en mémoire dudit serveur 100 et mise à disposition desdits compteurs électriques. Dans une autre variante de réalisation, l'étape 302 est effectuée par chaque compteur électrique considéré en requérant auprès du dispositif concentrateur 110 ou du serveur 100 quelle version de logiciel (identifiant et taille) est stockée en mémoire dudit serveur 100 et mise à disposition desdits compteurs électriques.

Dans une étape 303 suivante, des informations sur la dernière version logicielle partiellement ou intégralement téléchargée sur le compteur électrique considéré sont obtenues. Ces informations sont par exemple stockées dans une structure *image _to*_*activate_info* dont des champs *image _to*_*activate_identification* et *image_to_activate_size* sont des paramètres correspondant respectivement à l'identifiant de la dernière version de logiciel partiellement ou intégralement téléchargée sur le compteur électrique considéré et la taille de la dernière version de logiciel partiellement ou intégralement téléchargé sur le compteur électrique considéré. Ces informations sont incluses dans un contexte stocké en mémoire non volatile par chaque compteur électrique considéré d'après la dernière version de logiciel partiellement ou intégralement téléchargée sur ledit compteur électrique. L'étape 303 est préférentiellement effectuée par le dispositif concentrateur 110 en requérant auprès de chaque compteur électrique considéré quelle dernière version de logiciel (identifiant et taille) a été partiellement ou intégralement téléchargée sur ledit compteur électrique. Dans une variante de réalisation, l'étape 303 est préférentiellement effectuée par le serveur 100 en requérant auprès de chaque compteur électrique considéré quelle dernière version de logiciel (identifiant et taille) a été partiellement ou intégralement téléchargée sur ledit compteur électrique. Dans une autre variante de réalisation, l'étape 303 est effectuée par chaque compteur électrique considéré en consultant en interne quelle dernière version de logiciel (identifiant et taille) a été partiellement ou intégralement téléchargée sur ledit compteur électrique.

Dans une étape 304 suivante, les informations obtenues à l'étape 302 et les informations obtenues à l'étape 303 sont comparées pour vérifier si elles correspondent à une même version de logiciel. Si tel est le cas, une étape 305 est effectuée ; sinon, une étape 307 est effectuée. Si le transfert précédent avait été interrompu, de manière volontaire ou non, le passage de l'étape 304 à l'étape 307 signifie qu'une autre version de logiciel plus récente est disponible. L'étape 304 est préférentiellement effectuée par le dispositif concentrateur 110 à partir des informations obtenues par ledit dispositif concentrateur 110 aux étapes 302 et 303. Dans une autre variante de réalisation, l'étape 304 est effectuée par le serveur 100 à partir des informations obtenues par ledit serveur 100 aux étapes 302 et 303. Dans une autre variante de réalisation, l'étape 304 est effectuée par chaque compteur électrique considéré à partir des informations obtenues par ledit compteur électrique aux étapes 302 et 303.

Dans l'étape 305, il est vérifié si la dernière version de logiciel téléchargée sur le compteur électrique considéré l'a été intégralement ou bien si elle ne l'a été que partiellement. Une telle indication fait partie du contexte stocké en mémoire non volatile par ledit compteur électrique, via un paramètre *image_transfer_status* représentatif de la progression du téléchargement de la version du logiciel identifiée par le paramètre *image_to_activate_info.* Si la dernière version de logiciel téléchargée sur le compteur électrique considéré a été intégralement téléchargée sur le compteur électrique considéré, une étape 306 est effectuée ; si la dernière version de logiciel téléchargée sur le compteur électrique considéré n'a été que partiellement téléchargée sur le compteur électrique considéré, une étape 310 est effectuée. L'étape 305 est préférentiellement effectuée par le dispositif concentrateur 110 en requérant auprès de chaque compteur électrique considéré d'indiquer si la dernière version de logiciel a été intégralement téléchargée sur ledit compteur électrique ou si elle ne l'a été que partiellement. Dans une variante de réalisation, l'étape 305 est effectuée par le dispositif concentrateur 110 en requérant auprès de chaque compteur électrique considéré d'indiquer si la dernière version de logiciel a été intégralement téléchargée sur ledit compteur électrique ou si elle ne l'a été que partiellement. Dans une autre variante de réalisation, l'étape 305 est effectuée par chaque compteur électrique considéré en consultant en interne (dans son contexte stocké en mémoire non volatile) si la dernière version de logiciel a été intégralement téléchargée sur ledit compteur électrique ou si elle ne l'a été que partiellement. L'étape 305 est effectuée par le même dispositif que les étapes 302, 303 et 304.

Dans l'étape 306, il est mis fin à l'algorithme de la Fig.3, la version de logiciel disponible la plus à jour étant téléchargée sur chaque compteur électrique considéré.

Dans l'étape 307, la mise à jour logicielle est déclenchée et des paramètres de mise à jour logicielle en cours de transfert sont mémorisés par chaque compteur électrique considéré. En d'autres termes, ledit compteur électrique stocke dans son contexte en mémoire non volatile les champs *image_identifier* et *image_size* de la structure *image_transfer_initiate* respectivement dans les champs *image_to*_*activate_identification* et *image_to*_*activate_size* de la structure *image _to_activate_info,* la structure *image_transfer_initiate* étant fournie audit compteur électrique par le dispositif concentrateur du sous-réseau de communication auquel ledit compteur électrique est connecté. De plus, ledit compteur électrique stocke dans son contexte en mémoire non volatile le paramètre *image*_*transfer*_*status* indiquant qu'un transfert de version logicielle est en cours. L'étape 307 est préférentiellement effectuée par le dispositif concentrateur 110 en informant chaque compteur électrique considéré desdits paramètres de mise à jour logicielle. Dans une variante de réalisation, l'étape 307 est préférentiellement effectuée par le serveur 100 en informant chaque compteur électrique considéré desdits paramètres de mise à jour logicielle. Dans une autre variante de réalisation, l'étape 307 est effectuée par chaque compteur électrique considéré en informant le dispositif concentrateur 110 de sa volonté de télécharger la version de logiciel représentée par les informations obtenues à l'étape 302.

Les paramètres de mise à jour logicielle sont stockés en mémoire non volatile par les compteurs électriques considérés dans leurs contextes respectifs, ce qui simplifie une éventuelle reprise ultérieure du transfert de la nouvelle version du logiciel. Le fait que ces informations sont stockées par les compteurs électriques simplifie la préservation et la récupération de ces informations ; en effet, stocker ces informations sur le serveur 100 entraîne des difficultés de gestion des informations, notamment à cause des compteurs électriques qui peuvent être définitivement retirés du réseau de communication 120 et de ceux qui sont longuement déconnectés du réseau de communication 120 ; et stocker ces informations sur les dispositifs concentrateurs entraîne en outre des difficultés de gestion des compteurs électriques qui se déconnectent d'un sous-réseau de communication pour se reconnecter ultérieurement à un autre sous-réseau de communication.

Dans une étape 308 suivante, une première phase (phase I) de transfert de la nouvelle version de logiciel disponible auprès du serveur 100 est mise en place. Pendant ladite première phase de transfert, la nouvelle version du logiciel est transmise bloc par bloc. La nouvelle version du logiciel est ainsi décomposée en blocs successifs. Le serveur 100 fournit la nouvelle version du logiciel à chaque dispositif concentrateur du réseau de communication 120, au moins à celui de chaque sous-réseau de communication dans lequel il existe au moins un compteur électrique auquel ladite nouvelle version du logiciel est destinée. Le serveur 100 peut aussi fournir à chaque dispositif concentrateur une indication de tous les compteurs électriques concernés dans le sous-réseau de communication auquel ledit dispositif concentrateur appartient. Chaque dit dispositif concentrateur est alors en charge de propager, bloc par bloc, la nouvelle version du logiciel à chaque compteur électrique concerné dans le sous-réseau de communication dont ledit dispositif concentrateur est la racine. Le transfert pendant la première phase (phase I) se produit donc bloc après bloc selon un séquencement indépendant du fait que chaque bloc ait été ou non correctement reçu par chaque compteur électrique concerné. Préférentiellement, les blocs sont transférés successivement selon leur ordre d'apparition dans l'ensemble de blocs formant la nouvelle version du logiciel. On comprend de ce qui précède que le transfert pendant la première phase (phase I) est préférentiellement effectué à l'initiative du dispositif concentrateur concerné. Chaque dispositif concentrateur peut aussi connaître quels sont les compteurs électriques concernés dans le sous-réseau de communication auquel appartient ledit dispositif concentrateur en obtenant, auprès des compteurs électriques dudit sous-réseau de communication, leurs contextes respectifs. Les blocs peuvent ainsi être transmis en mode diffusion (« broadcast » en anglais), en mode point-multipoint (« multicast » en anglais) ou en mode point-à-point (« unicast » en anglais) selon la quantité de compteurs électriques concernés.

Des interférences ou phénomènes de diaphonie peuvent corrompre la réception de certains blocs par un ou plusieurs compteurs électriques, voire en empêcher toute réception. Les compteurs électriques doivent donc vérifier, pour chaque bloc, si ledit bloc a été reçu sans corruption. Chaque bloc comporte alors préférentiellement un code de vérification, tel qu'un CRC (« Cyclic Redundancy Checksum » en anglais) permettant au compteur électrique ayant reçu un bloc de déterminer si ledit bloc a été correctement reçu ou non.

Chaque bloc comporte un numéro de séquence, permettant au compteur électrique ayant reçu un bloc de déterminer sa position au sein de la nouvelle version du logiciel en cours de transfert. Chaque compteur électrique auquel est destiné le transfert de la nouvelle version du logiciel est ainsi capable de déterminer quel bloc a été correctement reçu par ledit compteur électrique. Au démarrage du téléchargement, tous les blocs sont considérés comme non correctement reçus et un drapeau (« flag » en anglais) au sein du contexte stocké en mémoire volatile du compteur électrique indique ce statut pour chaque bloc identifié par son numéro de séquence. Chaque fois qu'un bloc est correctement reçu, le compteur électrique modifie ce drapeau pour ledit bloc pour indiquer que ledit bloc a été correctement reçu. Ainsi, bien que le téléchargement s'opère selon un séquencement ne tenant pas compte de la réception effective desdits blocs, chaque compteur électrique sait, pour chaque bloc de la nouvelle version du logiciel, si ledit bloc a été correctement téléchargé ou non. Cette information est ultérieurement utile pour une seconde phase du transfert (ci-après, étape 310) ou pour une reprise du transfert suite à une interruption, volontaire ou non, du transfert.

A l'issue de la première phase du transfert, dans une étape 309 suivante, chaque compteur électrique auquel est destiné la nouvelle version du logiciel identifie les éventuels blocs non correctement reçus. La seconde phase du transfert peut alors être effectuée dans l'étape 310. Le transfert pendant la seconde phase (phase II) se produit donc bloc après bloc, mais en fonction des blocs non correctement reçus par chaque compteur électrique. Le contexte de chaque compteur électrique, tel que stocké dans sa mémoire non volatile, indique quels blocs ont été correctement reçus par ledit compteur électrique et quels blocs n'ont éventuellement pas été correctement reçus. Le contexte est alors utilisé dans la seconde phase pour déterminer quels blocs sont éventuellement à transférer depuis le dispositif concentrateur du sous-réseau de communication auquel est connecté ledit compteur électrique vers ledit compteur électrique.

Dans un mode de réalisation préférentiel, le transfert pendant la seconde phase (phase II) est à l'initiative du dispositif concentrateur du sous-réseau de communication auquel appartient chaque compteur électrique concerné. Chaque dispositif concentrateur requiert, auprès de chaque compteur électrique concerné dans le sous-réseau de communication auquel ledit dispositif concentrateur appartient, que lui soit fourni le contexte stocké par ledit compteur électrique. Ledit dispositif concentrateur détermine alors, pour chacun de ces compteurs électriques, quels blocs sont éventuellement manquants. Ledit dispositif concentrateur transmet alors à chacun de ces compteurs électriques chacun des blocs qui n'ont pas encore été correctement reçus par ledit compteur électrique. A chaque bloc correctement reçu pendant la seconde phase (phase II), ledit compteur électrique modifie le contexte de manière à ce que le drapeau associé audit bloc reflète que ledit bloc a été correctement reçu.

En variante de réalisation, le transfert pendant la seconde phase (phase II) est initié par chaque compteur électrique concerné. Ledit compteur électrique requiert alors auprès du dispositif concentrateur auquel ledit compteur électrique est rattaché chacun des blocs qui n'ont pas encore été correctement reçus. A chaque bloc correctement reçu pendant la seconde phase (phase II), le compteur électrique modifie le contexte de manière à ce que le drapeau associé audit bloc reflète que ledit bloc a été correctement reçu.

Le transfert de la seconde phase est répété jusqu'à ce que l'une des conditions suivantes soit remplie : tous les blocs sont correctement reçus par ledit compteur électrique concerné ; et ledit compteur électrique concerné est déconnecté.

Dans une étape 311, chaque compteur électrique ayant correctement reçu l'ensemble des blocs constituant la nouvelle version du logiciel stocke dans son contexte en mémoire non volatile une indication que le transfert de la nouvelle version du logiciel est achevé. En d'autres termes, ledit compteur électrique modifie dans son contexte en mémoire non volatile le paramètre *image_transfer_status* pour indiquer que le dernier transfert de version du logiciel est terminé. Puis, l'étape 306 est effectuée, mettant fin à l'algorithme de la Fig. 3. La version du logiciel ainsi transférée peut être activée par chaque compteur électrique ayant correctement reçu l'ensemble des blocs constituant la nouvelle version du logiciel.

Ainsi, lorsque l'étape 305 est suivie de l'étape 310, le transfert de la nouvelle version du logiciel reprend selon la seconde phase (phase II) lorsque le ou les compteurs électriques concernés se reconnectent, quel que soit le sous-réseau de communication auquel ledit ou lesdits compteurs électriques concernés se reconnectent. Chaque compteur électrique stocke en mémoire non volatile son propre contexte, ce qui permet de facilement reprendre le transfert par les blocs non encore correctement reçus, indépendamment du sous-réseau de communication auquel ledit compteur électrique se reconnecte suite à une déconnexion du réseau de communication 120.

Dans un exemple de réalisation, le paramètre *image_transfer_status* peut prendre une valeur parmi au moins les valeurs suivantes, en fonction de la progression du téléchargement de la version du logiciel sur le compteur électrique considéré :
- une valeur, dénommée *image_transfer_not_initiated,* indiquant que le transfert n'a pas encore été initié ; le paramètre *image_transfer_status* prend cette valeur quand la première phase (phase I) n'est pas encore enclenchée ;
- une valeur, dénommée *image_transfer_initiated,* indiquant que le transfert a été initié ; le paramètre *image_transfer_status* prend cette valeur quand la première phase (phase I) est enclenchée ; et
- une valeur, dénommée *image_verification_successful,* indiquant que le transfert a été réalisé et que la version du logiciel récupérée par le compteur électrique concerné a été vérifiée avec succès ; le paramètre *image_transfer_status* prend cette valeur dans l'étape 311.

L'ensemble de valeurs que le paramètre *image_transfer_status* peut prendre peut être enrichi avec des valeurs représentatives d'étapes intermédiaires de téléchargement, de vérification, voir d'activation de la version de logiciel considérée. Par exemple, cet ensemble de valeurs peut être enrichi avec les valeurs suivantes :
- une valeur, dénommée *image_vérification_initiated,* indiquant que la vérification de la version de logiciel téléchargée a été initiée ;
- une valeur, dénommée *image_verification_failed,* indiquant que la vérification de la version de logiciel téléchargée a été effectuée et a échoué ;
- une valeur, dénommée *image_activation_initiated,* indiquant que l'activation de la version de logiciel téléchargée a été initiée ;
- une valeur, dénommée *image_activation_successful,* indiquant que la version de logiciel téléchargée a été activée avec succès ; et
- une valeur, dénommée *image_activation_failed,* indiquant que l'activation de la version de logiciel téléchargée a échoué.

En cas d'échec, tel que potentiellement indiqué par le paramètre *image_transfer_status* comme montré ci-dessus, toute la procédure peut être réitérée ou une indication d'échec peut être fournie à un utilisateur via une interface homme-machine du compteur électrique concerné. Une telle indication d'échec peut aussi être fournie sous forme de message au dispositif concentrateur du sous-réseau de communication auquel appartient le compteur électrique concerné.

Dans un mode de réalisation particulier, la version du logiciel transférée contient une signature ou un code de vérification permettant au compteur électrique concerné de vérifier l'intégrité de la version de logiciel telle que reçue. Lorsque que le compteur électrique détermine que la version de logiciel telle que reçue est corrompue, le compteur électrique efface les blocs reçus et restaure son contexte tel qu'il était avant le transfert de cette version du logiciel. Cela signifie que ledit compteur électrique sauvegarde en mémoire non volatile le contexte précédent, avant que ne débute le transfert d'une nouvelle version de logiciel. Lorsque l'intégrité de la version logicielle reçue est vérifiée, ladite version du logiciel peut être activée.

## Revendications

1. Procédé de transfert d'une nouvelle version d'un logiciel à au moins un compteur électrique (130 ; 134 ; 138) dans un réseau de communication (120) comportant un serveur (100) et au moins un sous-réseau de communication (121) par courants porteurs en ligne, chaque compteur électrique se connectant au réseau de communication via un dit sous-réseau de communication par courants porteurs en ligne, chaque sous-réseau de communication par courants porteurs en ligne comportant un dispositif concentrateur (110) connecté au serveur, chaque dispositif concentrateur obtenant la nouvelle version du logiciel auprès du serveur et étant en charge de transférer la nouvelle version du logiciel dans le sous-réseau de communication par courants porteurs en ligne auquel ledit dispositif concentrateur appartient,
la nouvelle version du logiciel étant décomposée en blocs successifs, chaque bloc comportant un numéro de séquence pour déterminer s'il a été correctement reçu, le transfert de la nouvelle version du logiciel étant effectué par chaque dispositif concentrateur, bloc par bloc, en deux phases :
- une première phase pendant laquelle ledit dispositif concentrateur effectue (S308) le transfert selon un séquencement indépendant du fait que chaque bloc ait été ou non correctement reçu, et
- une seconde phase, ultérieure à la première phase, pendant laquelle le dispositif concentrateur effectue (S310) le transfert de chaque bloc non reçu ou n'ayant pas été correctement reçu par au moins un compteur électrique pendant la première phase,
le procédé étant **caractérisé en ce que**
chaque compteur électrique stocke en mémoire non volatile un contexte incluant une indication de chaque bloc de la nouvelle version du logiciel qui n'a pas été reçu ou correctement reçu, et, lorsque le transfert de la nouvelle version du logiciel vers au moins un compteur électrique est interrompu, la reprise ultérieure du transfert de la nouvelle version du logiciel vers ledit ou lesdits compteurs électriques s'effectue selon la seconde phase à l'aide du contexte,
**en ce que** le contexte stocke :
- des informations d'identification de la version du logiciel qui a été reçue par le compteur électrique concerné et de taille de ladite version du logiciel, lorsque tous les blocs de ladite version du logiciel ont été correctement reçus par ledit compteur électrique ;
- des informations d'identification de la version du logiciel qui est en cours de transfert et de taille de ladite version du logiciel, lorsque le transfert n'est pas encore achevé ;
et **en ce que**, lorsque le transfert de la nouvelle version du logiciel vers au moins un compteur électrique est interrompu, la reprise du transfert de la nouvelle version du logiciel vers ledit compteur électrique s'effectue selon la seconde phase si lesdites informations stockées dans ledit contexte correspondent à ladite nouvelle version du logicielle, et sinon, un transfert d'une autre version de logiciel plus récente est initié selon la première phase.

2. Procédé selon la revendication 1, **caractérisé en ce que** le transfert vers au moins un compteur électrique est interrompu par déconnexion dudit ou desdits compteurs électriques, et le transfert de la nouvelle version du logiciel vers ledit ou lesdits compteurs électriques reprend selon la seconde phase lorsque ledit ou lesdits compteurs électriques se reconnectent, quel que soit le sous-réseau de communication auquel ledit ou lesdits compteurs électriques se reconnectent.

3. Procédé selon l'une quelconque des revendications 1 et 2, **caractérisé en ce qu'**au démarrage du transfert, un drapeau au sein du contexte indique, associé à chaque bloc identifié par son numéro de séquence, que ledit bloc est considéré comme non correctement reçu, et chaque compteur recevant correctement un bloc l'indique par modification du drapeau associé audit bloc.

4. Procédé selon l'une quelconque des revendications 1 à 3, **caractérisé en ce que**, à chaque bloc correctement reçu par un compteur électrique, ledit compteur électrique modifie son contexte pour indiquer que ledit bloc a été correctement reçu, et **en ce que**, lors de ladite première phase, le transfert de la nouvelle version du logiciel à chaque compteur électrique concerné est à l'initiative du dispositif concentrateur auquel ledit compteur électrique est rattaché,
et **en ce que**, lors de la seconde phase, chaque dispositif concentrateur requiert auprès de chaque compteur électrique concerné dans le sous-réseau de communication auquel ledit dispositif concentrateur appartient de lui fournir le contexte dudit compteur électrique, et transmet à son initiative à chaque compteur électrique concerné chaque bloc qui n'a pas été correctement reçu d'après le contexte dudit compteur électrique, et ce de manière répétée jusqu'à ce que l'une des conditions suivantes soit remplie :
- tous les blocs sont correctement reçus par ledit compteur électrique ; et
- ledit compteur électrique est déconnecté.

5. Réseau de communication (120) comportant au moins un compteur électrique (130 ; 134 ; 138), un serveur (100) et au moins un sous-réseau de communication (121) par courants porteurs en ligne, chaque compteur électrique se connectant au réseau de communication via un dit sous-réseau de communication par courants porteurs en ligne, chaque sous-réseau de communication par courants porteurs en ligne comportant un dispositif concentrateur (110) connecté au serveur, chaque dispositif concentrateur obtenant auprès du serveur une nouvelle version du logiciel à transférer à au moins un dit compteur électrique et étant en charge de transférer la nouvelle version du logiciel dans le sous-réseau de communication par courants porteurs en ligne auquel ledit dispositif concentrateur appartient,
la nouvelle version du logiciel étant décomposée en blocs successifs, chaque bloc comportant un numéro de séquence pour déterminer s'il a été correctement reçu, le transfert de la nouvelle version du logiciel étant effectué par chaque dispositif concentrateur bloc par bloc en deux phases :
- une première phase pendant laquelle ledit dispositif concentrateur effectue (S308) le transfert selon un séquencement indépendant du fait que chaque bloc ait été ou non correctement reçu, et
- une seconde phase, ultérieure à la première phase, pendant laquelle le dispositif concentrateur effectue (S310) le transfert de chaque bloc n'ayant pas été reçu ou correctement reçu par au moins un compteur électrique pendant la première phase,
**caractérisé en ce que** chaque compteur électrique comporte une mémoire non volatile dans laquelle ledit compteur électrique stocke un contexte incluant une indication de chaque bloc de la nouvelle version du logiciel qui n'a pas été reçu ou correctement reçu, et, lorsque le transfert de la nouvelle version du logiciel vers au moins un compteur électrique est interrompu, la reprise ultérieure du transfert de la nouvelle version du logiciel vers ledit ou lesdits compteurs électriques s'effectue selon la seconde phase à l'aide du contexte,
**en ce que** le contexte stocke :
- des informations d'identification de la version du logiciel qui a été reçue par le compteur électrique concerné et de taille de ladite version du logiciel, lorsque tous les blocs de ladite version du logiciel ont été correctement reçus par ledit compteur électrique ;
- des informations d'identification de la version du logiciel qui est en cours de transfert et de taille de ladite version du logiciel, lorsque le transfert n'est pas encore achevé ;
et **en ce que**, lorsque le transfert de la nouvelle version du logiciel vers au moins un compteur électrique est interrompu, la reprise du transfert de la nouvelle version du logiciel vers ledit compteur électrique s'effectue selon la seconde phase si lesdites informations stockées dans ledit contexte correspondent à ladite nouvelle version du logicielle, et sinon, un transfert d'une autre version de logiciel plus récente est initié selon la première phase.

6. Procédé de transfert d'une nouvelle version d'un logiciel à au moins un compteur électrique, selon la revendication 1, le procédé étant implémenté par un dispositif concentrateur (110) et,
la reprise ultérieure du transfert de la nouvelle version du logiciel vers ledit ou lesdits compteurs électriques s'effectue à l'aide d'un ou plusieurs contextes qui sont stockés en mémoire non volatile dudit ou desdits compteurs électriques et qui incluent chacun une indication de chaque bloc de la nouvelle version du logiciel qui n'a pas été correctement reçu par le compteur électrique concerné.

7. Procédé de transfert d'une nouvelle version d'un logiciel à un compteur électrique, selon la revendication 1, le procédé étant implémenté par ledit compteur électrique.

8. Produit programme d'ordinateur comportant un ensemble d'instructions causant l'implémentation par un processeur du procédé selon la revendication 6 ou du procédé selon la revendication 7, lorsque lesdites instructions sont exécutées par ledit processeur.

9. Moyens de stockage d'informations stockant un programme d'ordinateur comportant un ensemble d'instructions causant l'implémentation par un processeur du procédé selon la revendication 6 ou du procédé selon la revendication 7, lorsque lesdites instructions sont exécutées par ledit processeur.

10. Dispositif concentrateur (110) destiné à transférer une nouvelle version d'un logiciel à au moins un compteur électrique (130 ; 134 ; 138) dans un réseau de communication (120) comportant un serveur (100) et au moins un sous-réseau de communication (121) par courants porteurs en ligne, chaque compteur électrique se connectant au réseau de communication via un dit sous-réseau de communication par courants porteurs en ligne, le dispositif concentrateur (110) étant destiné à être connecté au serveur, le dispositif concentrateur étant destiné à obtenir la nouvelle version du logiciel auprès du serveur et étant en charge de transférer la nouvelle version du logiciel dans un dit sous-réseau de communication par courants porteurs en ligne auquel ledit dispositif concentrateur appartient,
la nouvelle version du logiciel étant décomposée en blocs successifs, chaque bloc comportant un numéro de séquence pour déterminer s'il a été correctement reçu, le transfert de la nouvelle version du logiciel étant effectué par le dispositif concentrateur bloc par bloc en deux phases :
- une première phase pendant laquelle le dispositif concentrateur effectue (S308) le transfert selon un séquencement indépendant du fait que chaque bloc ait été ou non correctement reçu, et
- une seconde phase, ultérieure à la première phase, pendant laquelle le dispositif concentrateur effectue (S310) le transfert de chaque bloc n'ayant pas été reçu ou correctement reçu par au moins un compteur électrique pendant la première phase,
le dispositif concentrateur (110) étant **caractérisé en ce que**,
lorsque le transfert de la nouvelle version du logiciel vers au moins un compteur électrique est interrompu, le dispositif concentrateur est configuré de telle sorte que la reprise ultérieure du transfert de la nouvelle version du logiciel vers ledit ou lesdits compteurs électriques s'effectue selon la seconde phase à l'aide d'un ou plusieurs contextes qui sont stockés en mémoire non volatile dudit ou desdits compteurs électriques et qui incluent chacun une indication de chaque bloc de la nouvelle version du logiciel qui n'a pas été reçu ou correctement reçu par le compteur électrique concerné,
**en ce que** le contexte stocke :
- des informations d'identification de la version du logiciel qui a été reçue par le compteur électrique concerné et de taille de ladite version du logiciel, lorsque tous les blocs de ladite version du logiciel ont été correctement reçus par ledit compteur électrique ;
- des informations d'identification de la version du logiciel qui est en cours de transfert et de taille de ladite version du logiciel, lorsque le transfert n'est pas encore achevé ;
et **en ce que**, lorsque le transfert de la nouvelle version du logiciel vers au moins un compteur électrique est interrompu, la reprise du transfert de la nouvelle version du logiciel vers ledit compteur électrique s'effectue selon la seconde phase si lesdites informations stockées dans ledit contexte correspondent à ladite nouvelle version du logicielle, et sinon, un transfert d'une autre version de logiciel plus récente est initié selon la première phase.

11. Compteur électrique (130 ; 134 ; 138) destiné à recevoir une nouvelle version d'un logiciel via un réseau de communication (120) comportant un serveur (100) et au moins un sous-réseau de communication (121) par courants porteurs en ligne, le compteur électrique étant destiné à se connecter au réseau de communication via un dit sous-réseau de communication par courants porteurs en ligne, chaque sous-réseau de communication par courants porteurs en ligne comportant un dispositif concentrateur (110) connecté au serveur, chaque dispositif concentrateur obtenant la nouvelle version du logiciel auprès du serveur et étant en charge de transférer la nouvelle version du logiciel dans le sous-réseau de communication par courants porteurs en ligne auquel ledit dispositif concentrateur appartient,
la nouvelle version du logiciel étant décomposée en blocs successifs, chaque bloc comportant un numéro de séquence pour déterminer s'il a été correctement reçu, le transfert de la nouvelle version du logiciel étant effectué par chaque dispositif concentrateur bloc par bloc en deux phases :
- une première phase pendant laquelle ledit dispositif concentrateur effectue (S308) le transfert selon un séquencement indépendant du fait que chaque bloc ait été ou non correctement reçu, et
- une seconde phase, ultérieure à la première phase, pendant laquelle le dispositif concentrateur effectue (S310) le transfert de chaque bloc n'ayant pas été reçu ou correctement reçu par au moins un compteur électrique pendant la première phase,
le compteur électrique (130 ; 134 ; 138)
étant **caractérisé en ce qu'**il comporte des moyens pour stocker en mémoire non volatile un contexte incluant une indication de chaque bloc de la nouvelle version du logiciel qui n'a pas été reçu ou
correctement reçu, et, lorsque le transfert de la nouvelle version du logiciel vers le compteur électrique est interrompu, le compteur électrique est tel que la reprise ultérieure du transfert de la nouvelle version du logiciel vers le compteur électrique s'effectue selon la seconde phase à l'aide dudit contexte,
**en ce que** le contexte stocke :
- des informations d'identification de la version du logiciel qui a été reçue par le compteur électrique concerné et de taille de ladite version du logiciel, lorsque tous les blocs de ladite version du logiciel ont été correctement reçus par ledit compteur électrique ;
- des informations d'identification de la version du logiciel qui est en cours de transfert et de taille de ladite version du logiciel, lorsque le transfert n'est pas encore achevé ;
et **en ce que**, lorsque le transfert de la nouvelle version du logiciel vers au moins un compteur électrique est interrompu, la reprise du transfert de la nouvelle version du logiciel vers ledit compteur électrique s'effectue selon la seconde phase si lesdites informations stockées dans ledit contexte correspondent à ladite nouvelle version du logicielle, et sinon, un transfert d'une autre version de logiciel plus récente est initié selon la première phase.

## Patentansprüche

1. Verfahren zur Übertragung einer neuen Version einer Software an mindestens einen Stromzähler (130; 134; 138) in einem Kommunikationsnetz (120), das einen Server (100) und mindestens ein Powerline-Kommunikationsteilnetz (121) aufweist, wobei jeder Stromzähler über ein Powerline-Kommunikationsteilnetz mit dem Kommunikationsnetz verbunden ist, wobei jedes Powerline-Kommunikationsteilnetz eine mit dem Server verbundene Konzentratorvorrichtung (110) aufweist, wobei jede Konzentratorvorrichtung die neue Version der Software beim Server erhält und und dafür verantwortlich ist, die neue Version der Software in dem Powerline-Kommunikationsteilnetz zu übertragen, zu dem die Konzentratorvorrichtung gehört, wobei die neue Version der Software in aufeinanderfolgende Blöcke zergliedert ist, wobei jeder Block eine Folgenummer aufweist, um zu bestimmen, ob er korrekt empfangen wurde, wobei die Übertragung der neuen Version der Software von jeder Konzentratorvorrichtung Block für Block in zwei Phasen ausgeführt wird:
- einer ersten Phase, während der die Konzentratorvorrichtung die Übertragung gemäß einer Abfolgesteuerung unabhängig von der Tatsache ausführt (S308), ob jeder Block korrekt empfangen wurde oder nicht, und
- einer zweiten Phase, später als die erste Phase, während der die Konzentratorvorrichtung die Übertragung jedes von mindestens einem Stromzähler während der ersten Phase nicht empfangenen oder nicht korrekt empfangenen Blocks ausführt (S310),
wobei das Verfahren **dadurch gekennzeichnet ist, dass**
jeder Stromzähler in einem nichtflüchtigen Speicher einen Kontext speichert, der eine Anzeige jedes Blocks der neuen Version der Software enthält, der nicht empfangen oder korrekt empfangen wurde, und, wenn die Übertragung der neuen Version der Software an mindestens einen Stromzähler unterbrochen wird, die spätere Wiederaufnahme der Übertragung der neuen Version der Software an den oder die Stromzähler mit Hilfe des Kontexts gemäß der zweiten Phase ausgeführt wird,
dass der Kontext speichert:
- Informationen über die Identifizierung der Version der Software, die vom betroffenen Stromzähler empfangen wurde, und die Größe der Version der Software, wenn alle Blöcke der Version der Software vom Stromzähler korrekt empfangen wurden;
- Informationen über die Identifizierung der Version der Software, die gerade übertragen wird, und die Größe der Version der Software, wenn die Übertragung noch nicht beendet ist;
und dass, wenn die Übertragung der neuen Version der Software an mindestens einen Stromzähler unterbrochen wird, die Wiederaufnahme der Übertragung der neuen Version der Software an den Stromzähler gemäß der zweiten Phase ausgeführt wird, wenn die im Kontext gespeicherten Informationen der neuen Version der Software entsprechen, und sonst eine Übertragung einer anderen, neueren Softwareversion gemäß der ersten Phase gestartet wird.

2. Verfahren nach Anspruch 1, **dadurch gekennzeichnet, dass** die Übertragung an mindestens einen Stromzähler durch Trennen des oder der Stromzähler unterbrochen wird, und die Übertragung der neuen Version der Software an den oder die Stromzähler gemäß der zweiten Phase wieder beginnt, wenn der oder die Stromzähler sich wieder verbinden, unabhängig vom Kommunikationsteilnetz, mit dem der oder die Stromzähler sich wieder verbinden.

3. Verfahren nach einem der Ansprüche 1 und 2, **dadurch gekennzeichnet, dass** beim Start der Übertragung ein jedem durch seine Folgenummer identifizierten Block zugeordnetes Flag innerhalb des Kontexts anzeigt, dass der Block als nicht korrekt empfangen betrachtet wird, und jeder Zähler, der einen Block korrekt empfängt, dies durch Änderung des dem Block zugeordneten Flags anzeigt.

4. Verfahren nach einem der Ansprüche 1 bis 3, **dadurch gekennzeichnet, dass** bei jedem korrekt von einem Stromzähler empfangenen Block der Stromzähler seinen Kontext ändert, um anzuzeigen, dass der Block korrekt empfangen wurde, und dass in der ersten Phase die Übertragung der neuen Version der Software an jeden betroffenen Stromzähler auf Initiative der Konzentratorvorrichtung erfolgt, an die der Stromzähler angeschlossen ist,
und dass in der zweiten Phase jede Konzentratorvorrichtung von jedem betroffenen Stromzähler in dem Kommunikationsteilnetz, zu dem die Konzentratorvorrichtung gehört, fordert, ihr den Kontext des Stromzählers zu liefern, und auf eigene Initiative an jeden betroffenen Stromzähler jeden Block überträgt, der gemäß dem Kontext des Stromzählers nicht korrekt empfangen wurde, und dies wiederholt, bis eine der folgenden Bedingungen erfüllt ist:
- alle Blöcke wurden korrekt vom Stromzähler empfangen; und
- der Stromzähler ist getrennt.

5. Kommunikationsnetz (120), das mindestens einen Stromzähler (130; 134; 138), einen Server (100) und mindestens ein Powerline-Kommunikationsteilnetz (121) aufweist, wobei jeder Stromzähler sich über ein Powerline-Kommunikationsteilnetz mit dem Kommunikationsnetz verbindet, wobei jedes Powerline-Kommunikationsteilnetz eine mit dem Server verbundene Konzentratorvorrichtung (110) aufweist, wobei jede Konzentratorvorrichtung beim Server eine an mindestens einen Stromzähler zu übertragende neue Version der Software erhält und dafür verantwortlich ist, die neue Version der Software in dem Powerline-Kommunikationsteilnetz zu übertragen, zu dem die Konzentratorvorrichtung gehört,
wobei die neue Version der Software in aufeinanderfolgende Blöcke zergliedert ist, wobei jeder Block eine Folgenummer aufweist, um zu bestimmen, ob er korrekt empfangen wurde, wobei die Übertragung der neuen Version der Software von jeder Konzentratorvorrichtung Block für Block in zwei Phasen ausgeführt wird:
- einer ersten Phase, während der die Konzentratorvorrichtung die Übertragung gemäß einer Abfolgesteuerung unabhängig von der Tatsache ausführt (S308), ob jeder Block korrekt empfangen wurde oder nicht, und
- einer zweiten Phase, später als die erste Phase, während der die Konzentratorvorrichtung die Übertragung jedes Blocks ausführt (S310), der von mindestens einem Stromzähler während der ersten Phase nicht empfangen oder korrekt empfangen wurde,
**dadurch gekennzeichnet, dass** jeder Stromzähler einen nichtflüchtigen Speicher aufweist, in dem der Stromzähler einen Kontext speichert, der eine Anzeige jedes Blocks der neuen Version der Software umfasst, der nicht empfangen oder korrekt empfangen wurde, und, wenn die Übertragung der neuen Version der Software an mindestens einen Stromzähler unterbrochen wird, die spätere Wiederaufnahme der Übertragung der neuen Version der Software an den oder die Stromzähler mit Hilfe des Kontexts gemäß der zweiten Phase ausgeführt wird,
dass der Kontext speichert:
- Informationen über die Identifizierung der Version der Software, die vom betroffenen Stromzähler empfangen wurde, und die Größe der Version der Software, wenn alle Blöcke der Version der Software vom Stromzähler korrekt empfangen wurden;
- Informationen über die Identifizierung der Version der Software, die gerade übertragen wird, und die Größe der Version der Software, wenn die Übertragung noch nicht beendet ist;
und dass, wenn die Übertragung der neuen Version der Software an mindestens einen Stromzähler unterbrochen wird, die Wiederaufnahme der Übertragung der neuen Version der Software an den Stromzähler gemäß der zweiten Phase ausgeführt wird, wenn die im Kontext gespeicherten Informationen der neuen Version der Software entsprechen, und sonst eine Übertragung einer anderen, neueren Softwareversion gemäß der ersten Phase gestartet wird.

6. Verfahren zur Übertragung einer neuen Version einer Software an mindestens einen Stromzähler nach Anspruch 1, wobei das Verfahren von einer Konzentratorvorrichtung (110) implementiert wird, und
die spätere Wiederaufnahme der Übertragung der neuen Version der Software an den oder die Stromzähler mit Hilfe eines oder mehrerer Kontexte ausgeführt wird, die in einem nichtflüchtigen Speicher des oder der Stromzähler gespeichert sind und die je eine Anzeige jedes Blocks der neuen Version der Software umfassen, der vom betroffenen Stromzähler nicht korrekt empfangen wurde.

7. Verfahren zur Übertragung einer neuen Version einer Software an einen Stromzähler nach Anspruch 1, wobei das Verfahren vom Stromzähler implementiert wird.

8. Computerprogrammprodukt, das eine Einheit von Anweisungen aufweist, die die Implementierung des Verfahrens nach Anspruch 6 oder des Verfahrens nach Anspruch 7 durch einen Prozessor verursachen, wenn die Anweisungen vom Prozessor ausgeführt werden.

9. Informationsspeichereinrichtungen, die ein Computerprogramm speichern, das eine Einheit von Anweisungen aufweist, die die Implementierung des Verfahrens nach Anspruch 6 oder des Verfahrens nach Anspruch 7 durch einen Prozessor verursachen, wenn die Anweisungen vom Prozessor ausgeführt werden.

10. Konzentratorvorrichtung (110), die dazu bestimmt ist, eine neue Version einer Software an mindestens einen Stromzähler (130; 134; 138) in einem Kommunikationsnetz (120) zu übertragen, das einen Server (100) und mindestens ein Powerline-Kommunikationsteilnetz (121) aufweist, wobei jeder Stromzähler sich über ein Powerline-Kommunikationsteilnetz mit dem Kommunikationsnetz verbindet, wobei die Konzentratorvorrichtung (110) dazu bestimmt ist, mit dem Server verbunden zu werden, wobei die Konzentratorvorrichtung dazu bestimmt ist, die neue Version der Software beim Server zu erhalten und dafür verantwortlich ist, die neue Version der Software in einem Powerline-Kommunikationsteilnetz zu übertragen, zu dem die Konzentratorvorrichtung gehört,
wobei die neue Version der Software in aufeinanderfolgende Blöcke zergliedert ist, wobei jeder Block eine Folgenummer aufweist, um zu bestimmen, ob er korrekt empfangen wurde, wobei die Übertragung der neuen Version der Software von der Konzentratorvorrichtung Block für Block in zwei Phasen ausgeführt wird:
- einer ersten Phase, während der die Konzentratorvorrichtung die Übertragung gemäß einer Abfolgesteuerung unabhängig von der Tatsache ausführt (S308), ob jeder Block korrekt empfangen wurde oder nicht, und
- einer zweiten Phase, später als die erste Phase, während der die Konzentratorvorrichtung die Übertragung jedes Blocks ausführt (S310), der von mindestens einem Stromzähler während der ersten Phase nicht empfangen oder korrekt empfangen wurde,
wobei die Konzentratorvorrichtung (110) **dadurch gekennzeichnet ist, dass**,
wenn die Übertragung der neuen Version der Software an mindestens einen Stromzähler unterbrochen wird, die Konzentratorvorrichtung so konfiguriert ist, dass die spätere Wiederaufnahme der Übertragung der neuen Version der Software an den oder die Stromzähler gemäß der zweiten Phase mit Hilfe eines oder mehrerer Kontexte ausgeführt wird, die in einem nichtflüchtigen Speicher des oder der Stromzähler gespeichert sind und die je eine Anzeige jedes Blocks der neuen Version der Software umfassen, der vom betroffenen Stromzähler nicht empfangen oder korrekt empfangen wurde,
dass der Kontext speichert:
- Informationen über die Identifizierung der Version der Software, die vom betroffenen Stromzähler empfangen wurde, und die Größe der Version der Software, wenn alle Blöcke der Version der Software vom Stromzähler korrekt empfangen wurden;
- Informationen über die Identifizierung der Version der Software, die gerade übertragen wird, und die Größe der Version der Software, wenn die Übertragung noch nicht beendet ist;
und dass, wenn die Übertragung der neuen Version der Software an mindestens einen Stromzähler unterbrochen wird, die Wiederaufnahme der Übertragung der neuen Version der Software an den Stromzähler gemäß der zweiten Phase ausgeführt wird, wenn die im Kontext gespeicherten Informationen der neuen Version der Software entsprechen, und sonst eine Übertragung einer anderen, neueren Softwareversion gemäß der ersten Phase gestartet wird.

11. Stromzähler (130; 134; 138), der dazu bestimmt ist, eine neue Version einer Software über ein Kommunikationsnetz (120) zu empfangen, das einen Server (100) und mindestens ein Powerline-Kommunikationsteilnetz (121) aufweist, wobei der Stromzähler dazu bestimmt ist, sich über ein Powerline-Kommunikationsteilnetz mit dem Kommunikationsnetz zu verbinden, wobei jedes Powerline-Kommunikationsteilnetz eine mit dem Server verbundene Konzentratorvorrichtung (110) aufweist, wobei jede Konzentratorvorrichtung die neue Version der Software beim Server erhält und dafür verantwortlich ist, die neue Version der Software in dem Powerline-Kommunikationsteilnetz zu übertragen, zu dem die Konzentratorvorrichtung gehört,
wobei die neue Version der Software in aufeinanderfolgende Blöcke zergliedert ist, wobei jeder Block eine Folgenummer aufweist, um zu bestimmen, ob er korrekt empfangen wurde, wobei die Übertragung der neuen Version der Software von jeder Konzentratorvorrichtung Block für Block in zwei Phasen ausgeführt wird:
- einer ersten Phase, während der die Konzentratorvorrichtung die Übertragung gemäß einer Abfolgesteuerung unabhängig von der Tatsache ausführt (S308), ob jeder Block korrekt empfangen wurde oder nicht, und
- einer zweiten Phase, später als die erste Phase, während der die Konzentratorvorrichtung die Übertragung jedes Blocks ausführt (S310), der von mindestens einem Stromzähler während der ersten Phase nicht empfangen oder korrekt empfangen wurde,
wobei der Stromzähler (130; 134; 138) **dadurch gekennzeichnet ist, dass** er Einrichtungen aufweist, um in einem nichtflüchtigen Speicher einen Kontext zu speichern, der eine Anzeige jedes Blocks der neuen Version der Software enthält, der nicht empfangen oder korrekt empfangen wurde, und, wenn die Übertragung der neuen Version der Software an den Stromzähler unterbrochen wird, der Stromzähler so ist, dass die spätere Wiederaufnahme der Übertragung der neuen Version der Software an den Stromzähler mit Hilfe des Kontexts gemäß der zweiten Phase ausgeführt wird, dass der Kontext speichert:
- Informationen über die Identifizierung der Version der Software, die vom betroffenen Stromzähler empfangen wurde, und die Größe der Version der Software, wenn alle Blöcke der Version der Software vom Stromzähler korrekt empfangen wurden;
- Informationen über die Identifizierung der Version der Software, die gerade übertragen wird, und die Größe der Version der Software, wenn die Übertragung noch nicht beendet wurde;
und dass, wenn die Übertragung der neuen Version der Software an mindestens einen Stromzähler unterbrochen wird, die Wiederaufnahme der Übertragung der neuen Version der Software an den Stromzähler gemäß der zweiten Phase ausgeführt wird, wenn die im Kontext gespeicherten Informationen der neuen Version der Software entsprechen, und sonst eine Übertragung einer anderen, neueren Softwareversion gemäß der ersten Phase gestartet wird.

## Claims

1. Method for transferring a new version of a software program to at least one electric meter (130; 134; 138) over a communication network (120) comprising a server (100) and at least one power-line communication subnetwork (121), each electric meter being connected to the communication network via a said power-line communication subnetwork, each power-line communication subnetwork comprising a concentrator device (110) connected to the server, each concentrator device obtaining the new version of the software program from the server and being in charge of transferring the new version of the software program over the power-line communication subnetwork to which said concentrator device belongs,
the new version of the software program being broken down into successive blocks, each block comprising a sequence number for determining whether it has been received correctly, the transfer of the new version of the software program being made by each concentrator device, block by block, in two phases:
- a first phase during which said concentrator device makes (S308) the transfer according to a sequence which is independent of whether or not each block has been received correctly, and
- a second phase, subsequent to the first phase, during which the concentrator device makes (S310) the transfer of each block not received or not received correctly by at least one electric meter during the first phase,
the method being **characterized in that** each electric meter stores, in non-volatile memory, a context including an indication of each block of the new version of the software program which has not been received or received correctly and, when the transfer of the new version of the software program to at least one electric meter is interrupted, the transfer of the new version of the software program to said one or more electric meters is subsequently resumed according to the second phase using the context,
**in that** the context stores:
- information identifying the version of the software program which has been received by the relevant electric meter and about the size of said version of the software program, when all the blocks of said version of the software program have been received correctly by said electric meter;
- information identifying the version of the software program which is in the process of being transferred and about the size of said version of the software program, when the transfer is not yet complete;
and **in that**, when the transfer of the new version of the software program to at least one electric meter is interrupted, the transfer of the new version of the software program to said electric meter is resumed according to the second phase if said information stored in said context corresponds to said new version of the software program and, if not, a transfer of another, more recent software program version is initiated according to the first phase.

2. Method according to Claim 1, **characterized in that** the transfer to at least one electric meter is interrupted by said one or more electric meters being disconnected, and the transfer of the new version of the software program to said one or more electric meters resumes according to the second phase when said one or more electric meters are reconnected, whatever communication subnetwork said one or more electric meters are reconnected to.

3. Method according to either one of Claims 1 and 2, **characterized in that**, at the start of the transfer, a flag within the context indicates, associated with each block identified by its sequence number, that said block is considered as not received correctly, and each meter receiving a block correctly indicates it by modifying the flag associated with said block.

4. Method according to any one of Claims 1 to 3, **characterized in that**, each time a block is received correctly by an electric meter, said electric meter modifies its context so as to indicate that said block has been received correctly, and **in that**, during said first phase, the transfer of the new version of the software program to each relevant electric meter is on the initiative of the concentrator device to which said electric meter is linked,
and **in that**, during the second phase, each concentrator device asks each relevant electric meter in the communication subnetwork to which said concentrator device belongs to provide it with the context of said electric meter, and transmits, on its initiative and to each relevant electric meter, each block which has not been received correctly based on the context of said electric meter, and does so repeatedly until one of the following conditions is fulfilled:
- all the blocks are received correctly by said electric meter; and
- said electric meter is disconnected.

5. Communication network (120) comprising at least one electric meter (130; 134; 138), a server (100) and at least one power-line communication subnetwork (121), each electric meter being connected to the communication network via a said power-line communication subnetwork, each power-line communication subnetwork comprising a concentrator device (110) connected to the server, each concentrator device obtaining from the server a new version of the software program to be transferred to at least one said electric meter and being in charge of transferring the new version of the software program over the power-line communication subnetwork to which said concentrator device belongs,
the new version of the software program being broken down into successive blocks, each block comprising a sequence number for determining whether it has been received correctly, the transfer of the new version of the software program being made by each concentrator device block by block in two phases:
- a first phase during which said concentrator device makes (S308) the transfer according to a sequence which is independent of whether or not each block has been received correctly, and
- a second phase, subsequent to the first phase, during which the concentrator device makes (S310) the transfer of each block not received or received correctly by at least one electric meter during the first phase, **characterized in that** each electric meter comprises a non-volatile memory in which said electric meter stores a context including an indication of each block of the new version of the software program which has not been received or received correctly and, when the transfer of the new version of the software program to at least one electric meter is interrupted, the transfer of the new version of the software program to said one or more electric meters is subsequently resumed according to the second phase using the context,
**in that** the context stores:
- information identifying the version of the software program which has been received by the relevant electric meter and about the size of said version of the software program, when all the blocks of said version of the software program have been received correctly by said electric meter;
- information identifying the version of the software program which is in the process of being transferred and about the size of said version of the software program, when the transfer is not yet complete;
and **in that**, when the transfer of the new version of the software program to at least one electric meter is interrupted, the transfer of the new version of the software program to said electric meter is resumed according to the second phase if said information stored in said context corresponds to said new version of the software program and, if not, a transfer of another, more recent software program version is initiated according to the first phase.

6. Method for transferring a new version of a software program to at least one electric meter, according to Claim 1, the method being implemented by a concentrator device (110), and
the transfer of the new version of the software program to said one or more electric meters being subsequently resumed using one or more contexts which are stored in the non-volatile memory of said one or more electric meters and which each include an indication of each block of the new version of the software program which has not been received correctly by the relevant electric meter.

7. Method for transferring a new version of a software program to an electric meter, according to Claim 1, the method being implemented by said electric meter.

8. Computer program product comprising a set of instructions causing a processor to implement the method according to Claim 6 or the method according to Claim 7, when said instructions are executed by said processor.

9. Information storage means storing a computer program comprising a set of instructions causing a processor to implement the method according to Claim 6 or the method according to Claim 7, when said instructions are executed by said processor.

10. Concentrator device (110) intended to transfer a new version of a software program to at least one electric meter (130; 134; 138) over a communication network (120) comprising a server (100) and at least one power-line communication subnetwork (121), each electric meter being connected to the communication network via a said power-line communication subnetwork, the concentrator device (110) being intended to be connected to the server, the concentrator device being intended to obtain the new version of the software program from the server and being in charge of transferring the new version of the software program over a said power-line communication subnetwork to which said concentrator device belongs,
the new version of the software program being broken down into successive blocks, each block comprising a sequence number for determining whether it has been received correctly, the transfer of the new version of the software program being made by the concentrator device block by block in two phases:
- a first phase during which the concentrator device makes (S308) the transfer according to a sequence which is independent of whether or not each block has been received correctly, and
- a second phase, subsequent to the first phase, during which the concentrator device makes (S310) the transfer of each block not received or received correctly by at least one electric meter during the first phase,
the concentrator device (110) being **characterized in that**, when the transfer of the new version of the software program to at least one electric meter is interrupted, the concentrator device is configured such that the transfer of the new version of the software program to said one or more electric meters is subsequently resumed according to the second phase using one or more contexts which are stored in the non-volatile memory of said one or more electric meters and which each include an indication of each block of the new version of the software program which has not been received or received correctly by the relevant electric meter,
**in that** the context stores:
- information identifying the version of the software program which has been received by the relevant electric meter and about the size of said version of the software program, when all the blocks of said version of the software program have been received correctly by said electric meter;
- information identifying the version of the software program which is in the process of being transferred and about the size of said version of the software program, when the transfer is not yet complete;
and **in that**, when the transfer of the new version of the software program to at least one electric meter is interrupted, the transfer of the new version of the software program to said electric meter is resumed according to the second phase if said information stored in said context corresponds to said new version of the software program and, if not, a transfer of another, more recent software program version is initiated according to the first phase.

11. Electric meter (130; 134; 138) intended to receive a new version of a software program via a communication network (120) comprising a server (100) and at least one power-line communication subnetwork (121), the electric meter being intended to be connected to the communication network via a said power-line communication subnetwork, each power-line communication subnetwork comprising a concentrator device (110) connected to the server, each concentrator device obtaining the new version of the software program from the server and being in charge of transferring the new version of the software program over the power-line communication subnetwork to which said concentrator device belongs,
the new version of the software program being broken down into successive blocks, each block comprising a sequence number for determining whether it has been received correctly, the transfer of the new version of the software program being made by each concentrator device block by block in two phases:
- a first phase during which said concentrator device makes (S308) the transfer according to a sequence which is independent of whether or not each block has been received correctly, and
- a second phase, subsequent to the first phase, during which the concentrator device makes (S310) the transfer of each block not received or received correctly by at least one electric meter during the first phase,
the electric meter (130; 134; 138) being **characterized in that** it comprises means for storing, in non-volatile memory, a context including an indication of each block of the new version of the software program which has not been received or received correctly and, when the transfer of the new version of the software program to the electric meter is interrupted, the electric meter is such that the transfer of the new version of the software program to the electric meter is subsequently resumed according to the second phase using said context,
**in that** the context stores:
- information identifying the version of the software program which has been received by the relevant electric meter and about the size of said version of the software program, when all the blocks of said version of the software program have been received correctly by said electric meter;
- information identifying the version of the software program which is in the process of being transferred and about the size of said version of the software program, when the transfer is not yet complete;
and **in that**, when the transfer of the new version of the software program to at least one electric meter is interrupted, the transfer of the new version of the software program to said electric meter is resumed according to the second phase if said information stored in said context corresponds to said new version of the software program and, if not, a transfer of another, more recent software program version is initiated according to the first phase.
